# EUROPÄISCHE PATENTSCHRIFT

(11) **EP 1 053 568 B1**
(45) Veröffentlichungstag und Bekanntmachung des Hinweises auf die Patenterteilung: **26.04.2006**
(21) Anmeldenummer: 98966548.4
(22) Anmeldetag: 15.12.1998
(51) Int. Cl.: H01L 41/083, H01L 41/22

(54) **VERFAHREN ZUM POLARISIEREN VON PIEZOELEKTRISCHEN BAUELEMENTEN**
METHOD FOR POLARISING PIEZOELECTRIC COMPONENTS
PROCEDE POUR POLARISER DES COMPOSANTS PIEZOELECTRIQUES

(30) Priorität: 17.12.1997 DE 19756182
(43) Veröffentlichungstag der Anmeldung: 22.11.2000
(73) Patentinhaber: SIEMENS AKTIENGESELLSCHAFT, 80333 München (DE); SIEMENS MATSUSHITA COMPONENTS GmbH & CO. KG, 81541 München (DE)
(72) Erfinder: CRAMER, Dieter, D-83607 Holzkirchen (DE); LUBITZ, Karl, D-85521 Ottobrunn (DE); SCHUH, Carsten, D-85598 Baldham (DE); STEINKOPFF, Thorsten, D-85614 Eglharting (DE); WOLFF, Andreas, D-81739 München (DE)
(74) Vertreter: Epping - Hermann - Fischer
(86) Internationale Anmeldenummer: PCT/DE1998/003687
(87) Internationale Veröffentlichungsnummer: WO 1999/031739

(56) Entgegenhaltungen:
- EP-A- 0 350 941
- PATENT ABSTRACTS OF JAPAN vol. 014, no. 425 (E-0977), 13. September 1990 & JP 02 163983 A (TOYOTA MOTOR CORP), 25. Juni 1990
- PATENT ABSTRACTS OF JAPAN vol. 017, no. 006 (E-1302), 7. Januar 1993 & JP 04 239182 A (JAPAN AVIATION ELECTRON IND LTD), 27. August 1992
- PATENT ABSTRACTS OF JAPAN vol. 096, no. 001, 31. Januar 1996 & JP 07 240546 A (TOYOTA CENTRAL RES & DEV LAB INC), 12. September 1995

## Beschreibung

Die vorliegende Erfindung betrifft ein Verfahren zum Polarisieren von piezoelektrischen Bauelementen, insbesondere Piezoaktoren, die aus einer Vielzahl von Piezokeramik-schichten und dazwischen liegenden Metallelektroden gebildet sind. Weiterhin betrifft die Erfindung ein entsprechendes piezoelektrisches Bauelement.

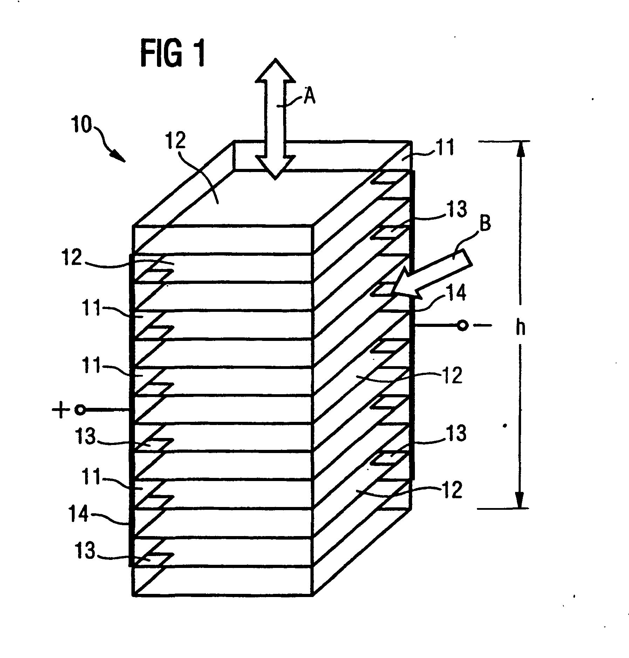

Piezoelektrische Bauelemente der genannten Art, beziehungsweise piezoelektrische monolithische Vielschicht-Piezoaktoren bestehen üblicherweise aus gemeinsam gesinterten Stapeln von Piezokeramik-Schichten mit dazwischen liegenden Metallelektroden. Jede Metallelektrode weist eine Aussparung auf, um dort die elektrischen Spannungen unterschiedlicher Polarität beim Polarisieren und beim späteren Betrieb des Bauelements zuzuführen. Die Aussparungen sind an jeder zweiten Elektrode an jeweils zwei gegenüberliegenden Kanten oder Seiten ausgebildet. Im Bereich der Aussparungen der Elektroden sind die jeweils übernächsten Elektroden mit einer von oben nach unten durchgehenden Metallisierungsbahn verbunden. Ein solches Bauelement ist in Figur 1 dargestellt und wird im Rahmen der Figurenbeschreibung näher erläutert.

Bei Betrieb solcher Bauelemente parallel zur Polarisationsrichtung werden zwar große Kräfte, aber nur kleine relative Auslenkungen erreicht. Zur Erzielung geringer Betriebsspannungen bestehen die Bauelemente aus einer Vielzahl von Einzelschichten. Zur Polarisierung der Bauelemente wird an diese ein elektrisches Polarisationsfeld angelegt, wodurch sich eine maximale remanente Polarisation und eine geordnete Verteilung der in Feldrichtung in den Kristallen der Keramik ausgerichteten Domänen gegenüber dem unpolarisierten Ausgangszustand ergibt. Nach der Polarisation ist das Bauelement bleibend in Richtung des angelegten Felds beziehungsweise der remanenten Polarisation verlängert. Diese bleibende Verlängerung hat zur Folge, daß im inaktiven und nicht durch Feldeinwirkung verlängerten Kontaktierungsbereich Zugspannungen auftreten. Dadurch können im piezoelektrisch inaktiven Kontaktierungsbereich bei der Polarisierung des Bauelements Risse parallel zu den Elektroden auftreten, die zwar im Übergangsbereich zum aktiven Bereich des Bauelements zum Stillstand kommen, die aber im späteren Betrieb des Bauelements zu Folgeschaden und schließlich zum Ausfall des Bauelements führen können. Weiterhin ist bei den bekannten Bauelementen von Nachteil, daß sich die Bauelemente nach Inbetriebnahme innerhalb der ersten Betriebszyklen noch in ihrer Lange und/oder ihrem Arbeitshub verändern. Die Bauelemente erreichen somit erst nach einer längeren Betriebsdauer ihren endgültigen Zustand, wodurch eine Nachjustage während des Betriebs notwendig wird. Dies ist insbesondere deshalb von Nachteil, da die Bauelemente üblicherweise im eingeklemmten Zustand betrieben werden. Es besteht deshalb ein Bedarf nach piezoelektrischen Bauteilen, die mit dem Betriebsbeginn des Bauteils eine stabile Anwendung gestatten.

Aus der Druckschrift JP-A-163983 ist ein Verfahren zum Polarisieren von piezoelektrischen Elementen bekannt.

Um das Auftreten von Polungsrissen zu vermeiden ist aus der EP-A-0 479 328 ein Verfahren bekannt, bei dem durch ein aufwendiges Sonderbedruckungs- und Stapelverfahren im inaktiven Kontaktierungsbereich parallel zu den Elektroden in den Keramikschichten vorbeugend Entlastungsschlitze erzeugt werden. Diese Entlastungsschlitze sollen die bei der Polarisierung entstehenden mechanischen Zugspannungen ähnlich wie die Polungsrisse selbst entlasten. Allerdings wird bei derartig ausgebildeten Bauelementen aufgrund der noch auftretenden Längenänderungen nach Betriebsbeginn ein stabiler Betriebszustand erst nach einer Reihe von Betriebszyklen erreicht.

Weiterhin ist bereits in allgemeiner Weise angedeutet worden, daß durch gleichzeitige Druckbelastung mit einem Druck von 30 bis 40 MPa bei der Polarisierung Polungsrisse vermieden werden können. Diese hohen Drücke können zwar zur Vermeidung von Polungsrissen beitragen, allerdings führen sie nicht zu einem stabilen Betrieb des Bauelements mit optimalen Kennwerten direkt ab Betriebsbeginn des Bauteils.

Ausgehend vom genannten Stand der Technik liegt der vorliegenden Erfindung die Aufgabe zugrunde, ein Verfahren zum Polarisieren von piezoelektrischen Bauelementen derart weiterzubilden, daß die genannten Nachteile vermieden werden. Insbesondere soll ein Verfahren bereitgestellt werden, durch das die Bauelemente auf solch eine Weise polarisiert werden, daß sie direkt ab Betriebsbeginn einen stabilen Betrieb mit optimalen Kennwerten ermöglichen, ohne daß es einer Nachjustage bedarf. Weiterhin soll auch erreicht werden, daß die Anzahl und die Größe der entstehenden Polungsrisse reduziert wird. Gemäß einem weiteren Aspekt der Erfindung soll ein piezoelektrisches Bauteil mit diesen vorteilhaften Eigenschaften bereitgestellt werden.

Die Aufgabe wird gemäß einem ersten Aspekt der Erfindung durch ein Verfahren der oben genannten Art gelöst, das durch folgende Schritte gekennzeichnet ist: a) Anlegen einer Druckspannung Tp an das zu polarisierende Bauelement vor Beginn der Polarisation und bis zum Ende der Polarisation, wobei die Druckspannung Tp der verlängernden Wirkung des anzulegenden elektrischen Polarisationsfelds entgegenwirkt und wobei für den Wert der Druckspannung Tp gilt: Tp < Td und Tp > 0, mit Td gleich dem Grenzdruck, der durch die Abweichung von der elastischen Geraden bestimmt ist; und b) Anlegen eines elektrischen Polarisationsfelds an das Bauelement, wobei die angelegte Feldstärke größer ist als die Koerzitivfeldstärke für das Bauelement.

Durch das erfindungsgemäße Verfahren wird ein über die gesamte Betriebsdauer des Bauelements -das heißt direkt ab Betriebsbeginn des Bauteils- stabiler Betriebszustand mit stabilen Kennwerten und einem stabilen Polarisierungszustand ermöglicht. Ein aufwendiges Nachjustieren der Bauelemente im eingebauten Zustand nach einer Reihe von Betriebszyklen kann somit entfallen. Da die Bauelemente üblicherweise eine maximale Betriebsdauer von bis zu 1x10⁹ Betriebszyklen haben, kann die Lebensdauer der Bauelemente optimal ausgenutzt werden, was neben verringerten Standzeiten der mit den Bauelementen bestückten Vorrichtungen auch zu einer erheblichen Kostenreduktion führt. Weiterhin wird die Anzahl und Größe der auftretenden Polungsrisse reduziert.

Durch das erfindungsgemäße Polarisationsverfahren wird beispielsweise erreicht, daß das Bauelement unter anderem einen im Betrieb stabileren thermischen Ausdehnungskoeffizienten aufweist, wodurch die Möglichkeit gegeben ist, unerwünschte Effekte durch thermische Längenänderungen über konstruktive Maßnahmen zu kompensieren.

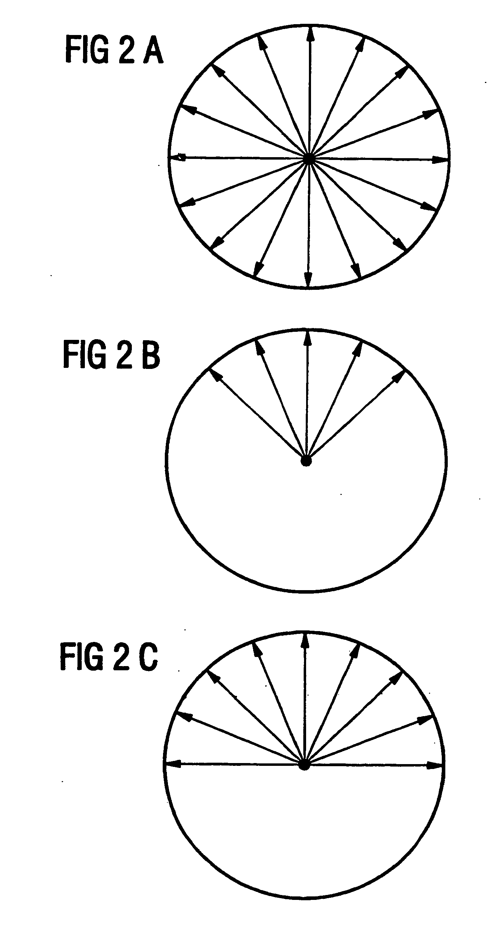

Das Keramikmaterial hat vorzugsweise eine Struktur, die das Auftreten von Piezoelektrizität gestattet. Dies wird durch Ferroelektrika mit Perowskitstruktur erreicht. Hierbei tritt bei Unterschreiten der Curietemperatur eine spontane Polarisation und damit auch eine Längenänderung auf, die mit einer Deformation des Kristallgitters verbunden ist. Die Deformation ergibt sich aus der Tatsache, daß nach dem Sintern der Keramik jedes kristalline Korn von anderen Körnern umgeben ist. Bei der Umwandlung in den ferroelektrischen Zustand wird jedes Korn spontan deformiert, gleichzeitig aber auch durch benachbarte Körner behindert. Auftretende innere Spannungen können teilweise nur durch Ausbildung von Domänen in den Körnern abgebaut werden. Dabei handelt es sich um eine tetragonale oder rhomboedrische Verzerrung des ursprünglichen kubischen Gitters, wodurch sich 180°- und 90°-Domänen in der tetragonalen Phase und 180°-, 71°- beziehungsweise 109°-Domänen in der rhomboedrischen Phase bilden. Nach der spontanen Polarisation sind die Dipolmomente der einzelnen Domänen so ausgerichtet, daß sie sich aufgrund der statistisch verteilten Polarisations-richtungen kompensieren. Dies ist in Figur 2a dargestellt und wird weiter unten näher beschrieben. Durch Einwirkung eines elektrischen Polarisationsfelds werden die Dipole in den einzelnen Kristalliten orientiert, wodurch eine Polarisation und Längenänderung des gesamten Körpers auftritt. Eine solche Polarisation ist in Figur 2b dargestellt und wird im Rahmen der Figurenbeschreibung näher erläutert.

Als Metallelektroden können beispielsweise -jedoch nicht ausschließlich- AgPd-Elektroden verwendet werden.

Erfindungsgemäß wird die Polarisation nicht am freien Bauteil, sondern unter einer gleichzeitig anliegenden Druckspannung Tp durchgeführt. Für die Druckspannung Tp, die der verlängernden Wirkung des elektrischen Polarisationsfelds entgegenwirkt und bereits vor Beginn des Anlegens der elektrischen Feldstärke bis zum Ende der Polarisation aufgebracht wird, gelten erfindungsgemäß zwei Einschränkungen.

Zunächst ist die Druckspannung Tp kleiner als der Grenzdruck Td zu wählen. Der Grenzdruck Td ergibt sich wie folgt: Sowohl in einer unpolarisierten als auch in einer polarisierten Piezokeramik lassen sich ab einem bestimmten Druck oder Zug, der durch die Abweichung von der elastischen Gerade im Spannungs-Dehnungs-Diagramm bestimmt ist, Domänen durch die Bewegung von 90°-, beziehungsweise 71°/109°-Domänenwänden umschalten, so daß auch nach Entfernen der mechanischen Belastung eine bleibende Längenänderung vorliegt. Dieser Druck wird im Sinne der vorliegenden Erfindung als Grenzdruck Td bezeichnet. Durch die Wahl der Druckspannung Tp kleiner als der Grenzdruck Td wird erreicht, daß nach der Polarisation noch ein ausreichend großer Anteil von schaltbaren und zur Auslenkung beitragenden Domänenwänden verbleibt. Der Grenzdruck Td hängt vom verwendeten Piezokeramikmaterial ab. Vorteilhaft beträgt der Grenzdruck Td < 20 MPa. Weiterhin muß die Druckspannung Tp größer als Null gewählt werden.

Nach der Beaufschlagung des zu polarisierenden Bauteils mit der Druckspannung Tp wird an das Bauelement ein elektrisches Polarisationsfeld angelegt, wobei die elektrische Feldstärke größer ist als die Koerzitivfeldstärke für das Bauelement. Dadurch wird das Bauelement in der vorstehend beschriebenen Weise polarisiert.

Der zeitliche Verlauf der bei der Polarisierung anliegenden Spannung kann einem trapezförmigen Verlauf entsprechen. Es ist aber auch ein sinusförmiger Verlauf, insbesondere mit variabler Frequenz denkbar. Insbesondere ist ein dem Betriebsfall mit maximaler Betriebsspannung entsprechender Verlauf am Ende der Polarisation vorteilhaft.

Durch die erfindungsgemäß gewählte Druckspannung Tp hat das Bauelement nach der Polarisierung eine geringe Längenänderung gegenüber dem unpolarisierten Ausgangszustand, was eine entsprechende Reduzierung der Zugspannungen im inaktiven Kontaktierungsbereich und eine sich daraus ableitende Reduktion der Anzahl und Größe von Polungsrissen zur Folge hat. Gleichzeitig ist die Höhe der Druckspannung Tp ausreichend niedrig gewählt, so daß nach der Polarisierung eine ausreichend große Anzahl an schaltbaren und zur Auslenkung beitragenden Domänenwänden verbleibt. Bei Verwendung eines zu hohen Drucks, wie dies beispielsweise zum Stand der Technik beschrieben wurde, können zwar die Polungsrisse vermieden werden, allerdings verbleibt nur ein sehr geringer Anteil von schaltbaren und zur Auslenkung beitragenden Domänenwänden. Bei deutlich niedrigerem Betriebsdruck ergibt sich dann der Nachteil eines instabilen Betriebs und die nachträgliche Entstehung von Rissen. Die erfindungsgemäße Polarisierung hat demnach zur Folge, daß die bei üblicher Polarisierung erreichbare Remanenz verringert ist. Dies hat allerdings den Vorteil, daß das Bauelement direkt ab Betriebsbeginn mit stabilen Kennwerten betrieben werden kann.

Vorteilhafte Ausgestaltungen des Verfahrens ergeben sich aus den rückbezogenen Unteransprüchen.

Erfindungsgemäß kann für den Wert der Druckspannung Tp weiterhin gelten: Tp ≥ Tb, mit Tb gleich dem statischen Druck, der im späteren Betrieb des Bauelements angelegt wird.

Im statischen und besonders im dynamischen Betrieb werden die Bauelemente in der Regel mit einem statischen Druck Tb beaufschlagt. Diese Vorlast hat zum Ziel, einen kraftschlüssigen Betrieb ohne Spalteneffekte zu gewährleisten sowie das Auftreten von dynamischen, trägheitsbedingten Zugspannungen zu verhindern. Vorteilhafte Werte für den statischen Druck liegen zwischen 10 und 20 MPa.

In weiterer Ausgestaltung kann die Druckspannung Tp einen Wert aufweisen, bei dem sich die Länge des Bauelements nach der Polarisation nur um maximal +30% bis -10% der bei druckloser Polarisation erreichten Längenänderung verändert. Dieser Wert ist materialabhängig und wird vorteilhaft experimentell ermittelt. Die Längenänderung bezieht sich in gleicher Weise auf das druckentlastete oder mit Druck beaufschlagte Bauelement.

Erfindungsgemäß kann die Druckspannung Tp einen Wert von 10 bis 20 MPa, vorzugsweise 15 bis 20 MPa aufweisen. Dies entspricht bei einem Bauelement mit einem Grundquerschnitt von 50mm² etwa einer Last von 0,5-1 kN. Bei einem solchen Wert für die Druckspannung Tp wird erreicht, daß die Druckspannung bei den oben beschriebenen vorteilhaften Werten für den Grenzdruck Td und den statischen Druck Tb die erforderlichen Bedingungen erfüllt.

Vorteilhaft kann die Druckspannung Tp über ein hydraulisches oder ein pneumatisches. System, oder aber durch Federkraft aufgebracht werden. Die Erfindung ist jedoch nicht auf die genannten Beispiele beschränkt.

In weiterer Ausgestaltung kann das elektrische Polarisationsfeld eine Feldstärke aufweisen, die kleiner ist als die Durchschlagsfestigkeit des Bauelements. Vorteilhaft ist sie experimentell so einzustellen, daß ein optimaler Arbeitshub des Bauelements erreicht wird. Vorteilhaft kann die Feldstärke dem zwei- bis fünffachen Wert der Koerzitivfeldstärke entsprechen.

In weiterer Ausgestaltung weist das elektrische Polarisationsfeld eine Feldstärke von 2 bis 2.5 kV/mm auf.

Erfindungsgemäß kann die Polarisation bei einer Polarisationstemperatur von 20 bis 150°C durchgeführt werden.

Vorteilhaft wird die Polarisation des Bauelements in einem isolierenden Medium durchgeführt, insbesondere in Luft, Öl oder Schutzgas.

Die Polarisationszeit kann erfindungsgemäß bis zu 700 Sekunden, vorzugsweise etwa 500 Sekunden betragen. Durch das erfindungsgemäße Verfahren zum Polarisieren von Bauelementen wird erreicht, daß die Bauelemente von Betriebsbeginn an stabile Kennwerte aufweisen. Weiterhin wird die Anzahl und Größe der auftretenden Polungsrisse reduziert. Das erfindungsgemäße Verfahren trägt dem Umstand Rechnung, daß bei im Großsignal mit hohen Feldstärken (siehe oben) betriebenen piezoelektrischen Bauelementen der kleinere Teil der Auslenkung durch den linearen, reversiblen, der Remanenz proportionalen Anteil des Piezoeffekts gegeben wird, und daß der größere Teil der Auslenkung durch die Bewegung von Domänenwänden bewirkt wird. Durch den erfindungsgemäß gewählten spezifischen Wert für die Druckspannung Tp wird während der Polarisation der Bauelemente erreicht, daß ein ausreichend großer Anteil von schaltbaren und zur Auslenkung beitragenden Domänenwänden verbleibt und gleichzeitig eine vorteilhafte Polarisation durchgeführt werden kann.

Die Anwendung des erfindungsgemäßen Polarisierungsverfahrens kann leicht überprüft werden, indem das polarisierte Bauelement über seine Curietemperatur erwärmt und somit einer thermischen Depolarisierung unterworfen wird und gleichzeitig seine Längenänderung bestimmt wird, die maximal 30% des bei einer drucklosen Polarisierung auftretenden Werts erreichen darf.

Gemäß einem zweiten Aspekt der vorliegenden Erfindung wird ein piezoelektrisches Bauelement bereitgestellt, insbesondere ein Piezoaktor, mit einer Vielzahl von Piezokeramik-Schichten und dazwischen liegenden Metallelektroden, wobei das Bauelement durch Anlegen eines elektrischen Polarisationsfelds polarisiert ist, dadurch gekennzeichnet, daß das Bauelement unter Anlegen einer Druckspannung Tp vor Beginn der Polarisation und bis zum Ende der Polarisation polarisiert ist, wobei die Druckspannung Tp der verlängernden Wirkung des anzulegenden elektrischen Polarisationsfelds entgegenwirkt und wobei für den Wert der Druckspannung Tp gilt: Tp < Td und Tp > 0, mit Td gleich dem Grenzdruck, der durch die Abweichung von der elastischen Geraden bestimmt ist.

Das erfindungsgemäße Bauelement weist stabile Kennwerte direkt ab Betriebsbeginn auf, so daß ein nachteiliges Nachjustieren zu einem späteren Zeitpunkt unterbleiben kann. Gleichzeitig wird die Anzahl und Größe der Polungsrisse verringert, was die Lebensdauer des Bauelements verlängert. Im Hinblick auf die Vorteile, Wirkungen, Effekte und Funktionen des erfindungsgemäßen Bauelements wird auf die vorstehenden Ausführungen zum erfindungsgemäßen Verfahren vollinhaltlich Bezug genommen und hiermit verwiesen.

Bevorzugte Ausgestaltungen des piezoelektrischen Bauelements ergeben sich aus den Unteransprüchen.

Bevorzugt ist das Bauelement nach einem wie vorstehend beschriebenen Verfahren hergestellt.

Vorteilhaft sind die einzelnen Metallelektroden über Metallisierungsbahnen miteinander verbunden.

In weiterer Ausgestaltung kann das Bauelement bis zu 1000 Einzelschichten, vorzugsweise 200 bis 400 Einzelschichten aufweisen.

Erfindungsgemäß kann das Bauelement eine Stapelhöhe von 5 bis 40 mm aufweisen.

In weiterer Ausgestaltung kann das Bauelement einen Arbeitshub von 5 bis 60 µm aufweisen.

Die Erfindung wird nun anhand von Ausführungsbeispielen unter Bezugnahme auf die beiliegende Zeichnung näher erläutert. Es zeigt:
- Figur 1: in schematischer Ansicht den Aufbau eines piezoelektrischen Bauelements; und
- Figur 2a bis 2c: verschiedene Polarisationszustände des Bauelements bei unterschiedlichen Bedingungen.

In Figur 1 ist ein als monolithischer Vielschicht-Piezoaktor ausgebildetes piezoelektrisches Bauelement 10 dargestellt. Das Bauelement 10 kann beispielsweise als Ventilantrieb fungieren und hat eine Betriebsdauer von bis zu 1x10⁹ Betriebszyklen. Das Bauelement 10 weist eine Vielzahl von Piezokeramikschichten 11 und dazwischen liegenden Metallelektroden 12 auf. Die Metallelektroden 12 weisen jeweils eine Aussparung 13 auf, wobei die Aussparungen 13 benachbarter Elektroden 12 jeweils an gegenüberliegenden Kanten oder Seiten der Elektroden 12 ausgebildet sind. Die im Bereich der Aussparungen 13 an die Oberfläche tretenden jeweiligen benachbarten, übernächsten Elektroden 12 sind über Metallisierungsbahnen 14 untereinander verbunden. Über die Metallisierungsbahnen 14 kann das Bauelement 10 mit einem elektrischen Feld zunächst zur Polarisierung und anschließend zum Betrieb beaufschlagt werden.

Um mit dem Bauelement 10 Arbeitshübe von 5 bis 60 µm erreichen zu können, ist eine Stapelhöhe h von 5 bis 40 mm erforderlich, was einer Anzahl von bis zu 1000 Einzelschichten 11, 12 entspricht.

Nach Unterschreiten der Curietemperatur weisen die gesinterten Keramikkörner der Keramikschichten 11 eine spontane Polarisation auf, die mit einer Deformation des Kristallgitters verbunden ist. Auftretende innere Spannungen können teilweise nur durch die Ausbildung von Domänen in den Körnern abgebaut werden. Nach der spontanen Polarisation sind die Dipolmomente der einzelnen Domänen so ausgerichtet, daß sie sich aufgrund der statistisch verteilten Polarisationsrichtungen kompensieren. Dies ist durch die entsprechenden Pfeile in Figur 2a dargestellt.

Durch Einwirkung eines elektrischen Polarisationsfelds am freien und ohne Druckspannung Tp beaufschlagten Bauelement 10 werden die Dipole in den einzelnen Kristalliten orientiert, wodurch eine Polarisation und Längenänderung des gesamten Körpers in Pfeilrichtung A auftritt. Eine solche Polarisation ist in Figur 2b dargestellt.

Durch die auftretenden Zugspannungen im inaktiven Kontaktierungsbereich B können bei der Polarisierung die sogenannten Polungsrisse auftreten.

Nachfolgend wird nun exemplarisch eine Ausführungsform des erfindungsgemäßen Polarisierungsverfahrens beschrieben.

Das zu polarisierende Bauelement 10 kann in ein Polarisationsmedium -beispielsweise Luft, Öl oder Schutzgas- eingebracht und wahlweise auf eine Polarisationstemperatur von 20 bis 150 °C gebracht werden. Bereits vor dem eigentlichen Polarisationsschritt wird das Bauelement mit einer Druckspannung Tp von 10 bis 20 MPa beaufschlagt. Dabei wirkt die Druckspannung Tp der verlängernden Wirkung des Polarisationsfelds, die durch den Pfeil A angedeutet ist, entgegen. Die Druckspannung Tp auf das Bauelement 10 wird während der gesamten Polarisation aufrechterhalten. Anschließend wird an dem Bauelement 10 über die Metallierungsbahnen 14 ein elektrisches Polarisationsfeld mit einer Stärke von 2 bis 2.5 kV/mm angelegt, was in Figur 1 durch die Symbole "+ und -" angedeutet ist. Nach Ablauf einer ausreichenden Polarisationszeit von etwa 500 Sekunden wird die Polarisation beendet, und das Bauelement 10 kann in den Betrieb übernommen werden.

Die erfindungsgemäße Polarisierung hat zur Folge, daß die bei üblicher, druckloser Polarisierung erreichbare Remanenz gemäß Figur 2b zunächst verringert ist. Dies ist in Figur 2c dargestellt. Allerdings verbleibt ein größerer Anteil von im Großsignalbetrieb schaltbaren und zur Auslenkung beitragenden Domänenwänden. Weiterhin ist durch die im Vergleich zu Figur 2b vorhandene geringere Polung gemäß Figur 2c eine Reduzierung der Anzahl und Größe von Polungsrissen möglich. Das gemäß Figur 2c polarisierte Bauelement 10 weist einen stabilen Betrieb mit entsprechenden stabilen Kennwerten direkt ab Betriebsaufnahme auf, so daß Einschwing-Betriebszyklen nach Betriebsaufnahme sowie ein nachteiliges Nachjustieren entfallen können.

Die Polarisation der Bauelemente kann gemäß einer ersten Ausführungsvariante zunächst in einer separaten Vorrichtung durchgeführt werden. Nach der Polarisierung wird das Bauelement aus dieser Vorrichtung entnommen und in seiner dafür vorgesehenen Betriebsumgebung eingebaut. Nach dem Einbau des polarisierten Bauelements wird das Bauelement anschließend mit einem für den Betrieb vorteilhaften statischen Druck Tb beaufschlagt.

Gemäß einer anderen Ausführungsvariante erfolgt die Polarisation des Bauelements am späteren Betriebsort des Bauelements. Das hat den Vorteil, daß die Druckspannung Tp nach Beendigung der Polarisation nicht mehr entfernt werden muß. Das Bauelement kann also zunächst unpolarisiert in seine endgültige Betriebsumgebung eingebaut, mit Druck beaufschlagt, polarisiert und anschließend betrieben werden. Da das Bauteil bei der erfindungsgemäßen Polarisierung seine Gesamtlänge nur geringfügig ändert, kann eine entsprechende Anordnung wie folgt realisiert werden: Das unpolarisierte Bauelement -beispielsweise ein Aktor- wird in das Innere einer mit einem festen Boden verschlossenen Rohrfeder eingesetzt. Die Rohrfeder wird mit einer dem Polarisationsdruck Tp, beziehungsweise dem Betriebsdruck entsprechenden Kraft gedehnt. Anschließend wird eine Deckplatte in die Rohrfeder eingesetzt und mit der Rohrfeder verschweißt. Der so unter Druckspannung in die Rohrfeder eingebaute Aktor wird anschließend erfindungsgemäß polarisiert und in gleicher Anordnung betrieben.

## Patentansprüche

1. Verfahren zum Polarisieren von piezoelektrischen Bauelementen, die aus einer Vielzahl von Piezokeramik-Schichten und dazwischen liegenden Metallelektroden gebildet sind, mit folgenden Schritten:
a) Ermitteln des Grenzdrucks Td, der durch die Abweichung von der elastischen Geraden im Spannungs-Dehnungs-Diagramm des verwendeten Keramikmaterials bestimmt ist;
b) Anlegen einer Druckspannung Tp an das zu polarisierende Bauelement vor Beginn der Polarisation und bis zum Ende der Polarisation, wobei die Druckspannung Tp der verlängernden Wirkung des anzulegenden elektrischen Polarisationsfelds entgegenwirkt und wobei für den Wert der Druckspannung Tp gilt: Tp < Td und Tp > 0;
c) Anlegen eines elektrischen Polarisationsfelds an das Bauelement, wobei die angelegte Feldstärke größer ist als die Koerzitivfeldstärke für das Bauelement.

2. Verfahren nach Anspruch 1, **dadurch gekennzeichnet, daß** für den Wert der Druckspannung Tp weiterhin gilt: Tp ≥ Tb, mit Tb gleich dem statischen Druck, der im späteren Betrieb des Bauelements angelegt wird.

3. Verfahren nach Anspruch 1 oder 2, **dadurch gekennzeichnet, daß** die Druckspannung Tp einen Wert aufweist, bei dem sich die Länge des Bauelements nach der Polarisation um maximal +30% bis -10% des bei druckloser Polarisation erreichten Werts verändert.

4. Verfahren nach einem der Ansprüche 1 bis 3, **dadurch gekennzeichnet, daß** die Druckspannung Tp einen Wert von 10 bis 20 MPa, vorzugsweise 15 bis 20 MPa aufweist.

5. Verfahren nach einem der Ansprüche 1 bis 4, **dadurch gekennzeichnet, daß** die Druckspannung Tp über ein hydraulisches oder pneumatisches System oder durch Federkraft aufgebracht wird.

6. Verfahren nach einem der Ansprüche 1 bis 5, **dadurch gekennzeichnet, daß** das elektrische Polarisationsfeld eine Feldstärke aufweist, die kleiner ist als die Durchschlagfestigkeit des Bauelements und insbesondere dem zwei- bis fünffachen Wert der Koerzitivfeldstärke entspricht.

7. Verfahren nach einem der Ansprüche 1 bis 6, **dadurch gekennzeichnet, daß** das elektrische Polarisationsfeld eine Feldstärke von 2 bis 2.5 kV/mm aufweist.

8. Verfahren nach einem der Ansprüche 1 bis 7, **dadurch gekennzeichnet, daß** die Polarisation bei einer Polarisationstemperatur von 20 bis 150 °C durchgeführt wird.

9. Verfahren nach einem der Ansprüche 1 bis 8, **dadurch gekennzeichnet, daß** die Polarisation in einem isolierenden Medium durchgeführt wird, insbesondere in Luft, Öl oder Schutzgas.

10. Verfahren nach einem der Ansprüche 1 bis 9, **dadurch gekennzeichnet, daß** die Polarisationszeit bis 700 Sekunden, insbesondere etwa 500 Sekunden beträgt.

## Claims

1. Method for polarizing piezoelectric components which are formed by a multiplicity of piezoceramic layers and metal electrodes lying between them, having the following steps:
a) finding the limiting pressure Td which is determined by the deviation from the elastic straight line in the stress-strain diagram of the ceramic material being used;
b) applying a compressive stress Tp to the component to be polarized, before the start of the polarization and until the end of the polarization, the compressive stress Tp counteracting the lengthening effect of the electrical polarization field to be applied and the value of the compressive stress Tp satisfying: Tp < Td and Tp > 0;
c) applying an electrical polarization field to the component, the applied field strength being greater than the coercive field strength for the component.

2. Method according to Claim 1, **characterized in that** value of the compressive stress Tp furthermore satisfies: Tp ≥ Tb, where Tb is equal to the static pressure which is applied during subsequent operation of the component.

3. Method according to Claim 1 or 2, **characterized in that** the compressive stress Tp has a value at which the length of the component after polarization varies by at most +30% to -10% of the value reached with pressureless polarization.

4. Method according to one of Claims 1 to 3, **characterized in that** the compressive stress Tp has a value of from 10 to 20 MPa, preferably from 15 to 20 MPa.

5. Method according to one of Claims 1 to 4, **characterized in that** the compressive stress Tp is applied using a hydraulic or pneumatic system or by spring force.

6. Method according to one of Claims 1 to 5, **characterized in that** the electrical polarization field has a field strength which is less than the breakdown strength of the component and, in particular, corresponds to from two to five times the value of the coercive field strength.

7. Method according to one of Claims 1 to 6, **characterized in that** the electrical polarization field has a field strength of from 2 to 2.5 kV/mm.

8. Method according to one of Claims 1 to 7, **characterized in that** the polarization is carried out at a polarization temperature of from 20 to 150°C.

9. Method according to one of Claims 1 to 8, **characterized in that** the polarization is carried out in an insulating medium, particularly in air, oil or protective gas.

10. Method according to one of Claims 1 to 9, **characterized in that** the polarization time is up to 700 seconds, in particular about 500 seconds.

## Revendications

1. Procédé de polarisation de composants piézoélectriques, qui sont formés d'une pluralité de couche piézocéramiques et d'électrodes métalliques entre elles, comprenant les stades suivants :
a) on détermine la compression Td limite qui est définie par l'écart à des droites élastiques dans le graphique effort-allongement du matériau céramique utilisé;
b) on applique un effort Tp de compression au composant à polariser avant le début de la polarisation et jusqu'à la fin de la polarisation, l'effort Tp de compression s'opposant à l'effet d'allongement du champ de polarisation électrique appliqué et en ayant pour la valeur de l'effort Tp de compression : Tp < Td et Tp > 0 ;
c) on applique un champ de polarisation électrique au composant, l'intensité du champ appliquée étant plus grande que l'intensité du champ coercitif pour le composant.

2. Procédé suivant la revendication 1, **caractérisé en ce que**, pour la valeur de l'effort Tp de compression on a, en outre : Tp ≥ Tb, Tb étant égal à la compression statique qui est appliquée dans le fonctionnement ultérieur du composant.

3. Procédé suivant la revendication 1 ou 2, **caractérisé en ce que** l'effort Tp de compression a une valeur pour laquelle la longueur du composant se modifie après la polarisation au maximum de +30 % à -10 % de la valeur obtenue dans la polarisation sans compression.

4. Procédé suivant l'une des revendications 1 à 3, **caractérisé en ce que** l'effort Tp de compression a une valeur de 10 à 20 MPa, de préférence de 15 à 20 MPa.

5. Procédé suivant l'une des revendications 1 à 4, **caractérisé en ce que** l'effort Tp de compression est appliqué par un système hydraulique ou pneumatique ou par une force de ressort.

6. Procédé suivant l'une des revendications 1 à 5, **caractérisé en ce que** le champ de polarisation électrique a une intensité qui est inférieure à la rigidité diélectrique du composant et qui correspond notamment à la valeur de 2 à 5 fois de l'intensité du champ coercitif.

7. Procédé suivant l'une des revendications 1 à 6, **caractérisé en ce que** le champ de polarisation électrique a une intensité de 2 à 2,5 kV/mm.

8. Procédé suivant l'une des revendications 1 à 7, **caractérisé en ce que** l'on effectue la polarisation à une température de polarisation de 20 à 150°C.

9. Procédé suivant l'une des revendications 1 à 8, **caractérisé en ce que** l'on effectue la polarisation dans un milieu isolant, notamment dans l'air, dans l'huile ou dans un gaz de protection.

10. Procédé suivant l'une des revendications 1 à 9, **caractérisé en ce que** la durée de polarisation va jusqu'à 700 secondes et, notamment, est d'environ 500 secondes.
